# EUROPEAN PATENT APPLICATION

(11) **EP 4 395 135 A1**
(43) Date of publication of application: **03.07.2024**
(21) Application number: 22861204.0
(22) Date of filing: 17.08.2022
(51) Int. Cl.: H02K 3/26, H01F 5/00, H05K 1/16

(54) **COIL SUBSTRATE, MOTOR COIL SUBSTRATE, AND MOTOR**

(30) Priority: 24.08.2021 JP 2021136207
(71) Applicant: IBIDEN CO., LTD., Ogaki-shi, Gifu 503-8604 (JP)
(72) Inventor: HIRASAWA, Takahisa, Ogaki-shi, Gifu 503-8503 (JP); FURUNO, Takayuki, Ogaki-shi, Gifu 503-8503 (JP)
(74) Representative: Hoefer & Partner Patentanwälte mbB
(86) International application number: PCT/JP2022/031047
(87) International publication number: WO 2023/026916

(57) **Abstract**

Provided are: a coil board which ensures a withstand voltage and enables a motor having stable performance to be obtained, a motor coil board formed by using the coil board, and a motor formed by using the motor coil board. A coil board of an embodiment comprises: a flexible board having a first face and a second face on the opposite side to the first face; and a plurality of coils formed by coil-shaped wires provided on the first face and coil-shaped wires provided on the second face. The plurality of coils include an N^{th} (N = 1, 2...) coil forming an N^{th} phase, and an N+1^{th} coil forming an N+1^{th} phase, the N+1^{th} coil being arranged next to the N^{th} coil. An inter-wire distance between the wires constituting the N^{th} coil and the wires constituting the N+1^{th} coil is greater than an inter-wire distance of the wires constituting the N^{th} coil and an inter-wire distance of the wires constituting the N+1^{th} coil.

## Description

### Technical Field

The technology disclosed in the present specification relates to a coil board, a motor coil board formed by using the coil board, and a motor formed by using the motor coil board.

### Background Art

Patent Document 1 describes a coil board comprising a flexible board and spiral-shaped wires formed on both surfaces of the flexible board. A motor coil board is formed by winding the coil board into a cylindrical shape. A motor is formed by arranging the formed motor coil board on the inside of a cylindrical yoke, and arranging a rotary shaft and a magnet on the inside of the motor coil board.

### Prior Art Documents

### Patent Documents

Patent Document 1: JP 2020-61532 A

### Summary of the Invention

### [Problems in Patent Document 1]

The coil board of Patent Document 1 may comprise a plurality of coils constituting three phases, namely a U phase, V phase and W phase. In that case, when the coil board is wound into a cylindrical shape, it is feasible that the wires of two adjacent coils constituting different phases will be close to each other. When a high voltage is applied, it is feasible that there will be a short circuit between the wires of the two adjacent coils constituting different phases.

### Means for Solving the Problems

A coil board of the present invention comprises: a flexible board having a first face and a second face on the opposite side to the first face; and a plurality of coils formed by coil-shaped wires provided on the first face and coil-shaped wires provided on the second face. The plurality of coils include an N^{th} (N = 1, 2...) coil forming an N^{th} phase, and an N+1^{th} coil forming an N+1^{th} phase, the N+1^{th} coil being arranged next to the N^{th} coil. An inter-wire distance between the wires constituting the N^{th} coil and the wires constituting the N+1^{th} coil is greater than an inter-wire distance of the wires constituting the N^{th} coil and an inter-wire distance of the wires constituting the N+1^{th} coil.

In a coil board according to an embodiment of the present invention, the inter-wire distance between the wires constituting the N^{th} coil and the wires constituting the N+1^{th} coil is greater than the inter-wire distance of the wires constituting the N^{th} coil and the inter-wire distance of the wires constituting the N+1^{th} coil. When the coil board is wound into a cylindrical shape in order to form a motor coil board, a distance is therefore maintained between the wires constituting the N^{th} coil and the wires constituting the adjacent N+1^{th} coil, and there is no contact between the wires. The occurrence of a short circuit between the N^{th} phase the N+1^{th} phase is also suppressed when a high voltage is applied. When a motor is formed by using a coil board comprising coils of multiple phases, a withstand voltage of the motor is ensured and a motor having stable performance can be obtained.

A motor coil board of the present invention is formed by winding the coil board of the present invention into a cylindrical shape. The first face is arranged on an inner circumferential side and the second face is arranged on an outer circumferential side.

In a motor coil board according to an embodiment of the present invention, a distance is maintained between the wires constituting the N^{th} coil and the wires constituting the adjacent N+1^{th} coil, and there is no contact between the wires, as indicated above. The occurrence of a short circuit between the N^{th} phase the N+1^{th} phase is also suppressed when a high voltage is applied. When a motor is formed by using the motor coil board, a withstand voltage of the motor is ensured and a motor having stable performance can be obtained.

A motor of the present invention is formed by arranging the motor coil board of the present invention on the inside of a cylindrical yoke, and arranging a rotary shaft and a magnet on the inside of the motor coil board.

In a motor according to an embodiment of the present invention, the occurrence of a short circuit between the N^{th} phase the N+1^{th} phase is also suppressed when a high voltage is applied. A withstand voltage of the motor is ensured and a motor having stable performance can be obtained.

### Brief Description of the Drawings

[Fig. 1] is a plan view schematically showing a coil board according to an embodiment.
[Fig. 2] is a view in cross section schematically showing a portion of the coil board according to an embodiment.
[Fig. 3] is an oblique view schematically showing a motor coil board according to an embodiment.
[Fig. 4] is an enlarged explanatory diagram of a portion of fig. 3.
[Fig. 5] is a view in cross section schematically showing a motor according to an embodiment.
[Fig. 6] is a plan view schematically showing a coil board according to a first modified example of the embodiment.
[Fig. 7] is a bottom view schematically showing the coil board according to the first modified example of the embodiment.
[Fig. 8] is a view in cross section schematically showing a portion of the coil board according to the first modified example.

### Embodiments of the Invention

### [Embodiments]

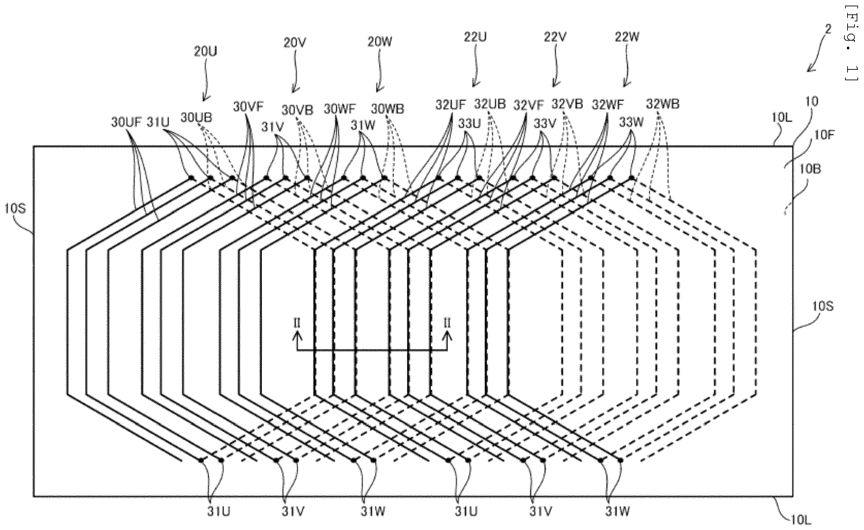

Fig. 1 is a plan view showing a coil board 2 according to an embodiment. The coil board 2 comprises a flexible board 10, and a plurality of coils 20U, 20V, 20W, 22U, 22V, 22W. The coil board 2 is a coil board for a three-phase motor. The coils 20U, 22U form a U phase. The coils 20V, 22V form a V phase. The coils 20W, 22W form a W phase.

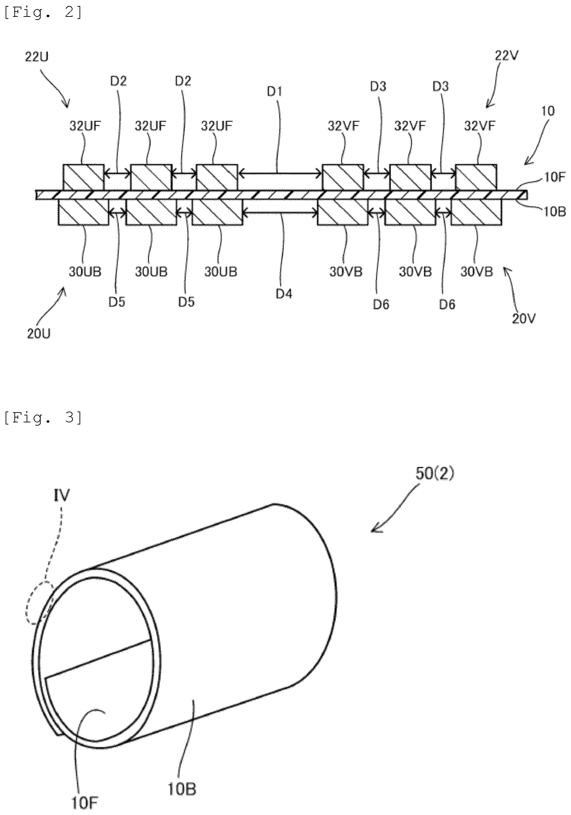

The flexible board 10 is a resin board comprising a first face 10F and a second face 10B on the opposite side to the first face 10F. The flexible board 10 is formed by using an insulating resin such as polyimide or polyamide. The flexible board 10 is capable of flexing. The flexible board 10 is formed in a rectangular shape having short sides 10S and long sides 10L. When a motor coil board 50 (see fig. 3) is formed by winding the coil board 2 into a cylindrical shape, as will be described in detail later, the first face 10F is arranged on an inner circumferential side and the second face 10B is arranged on an outer circumferential side.

The coils 20U, 20V, 20W, 22U, 22V, 22W are aligned along the long sides 10L of the flexible board 10. As mentioned above, the coils 20U, 22U form the U phase. The coils 20V, 22V form the V phase. The coils 20W, 22W form the W phase. The V-phase coils 20V, 22V are arranged next to the U-phase coils 20U, 22U. The W-phase coils 20W, 22W are arranged next to the V-phase coils 20V, 22V. In the embodiment, the flexible board 10 is provided with six coils 20U, 20V, 20W, 22U, 22V, 22W (i.e., two sets of three-phase coils), but in a modified example, the flexible board 10 may be provided with 3X (where X is an integer of 1 or 3 or more) coils (i.e., one set or three or more sets of three-phase coils).

In order to form the coil 20U, a first wire 30UF constituting a half turn of one turn is formed on the first face 10F side, a second wire 30UB constituting a remaining half turn is formed on the second face 10B side, and adjacent turns are arranged offset from each other. In fig. 1, the coil 20U comprises three turns of wires. The first wire 30UF and the second wire 30UB constituting each turn are electrically connected through via conductors 31U penetrating the flexible board 10.

In the same way, in order to form the coil 20V, a first wire 30VF constituting a half turn of one turn is formed on the first face 10F side, a second wire 30VB constituting a remaining half turn is formed on the second face 10B side, and adjacent turns are arranged offset from each other. The coil 20V comprises three turns of wires. The first wire 30VF and the second wire 30VB constituting each turn are electrically connected through via conductors 31V penetrating the flexible board 10. In order to form the coil 20W, a first wire 30WF constituting a half turn of one turn is formed on the first face 10F side, a second wire 30WB constituting a remaining half turn is formed on the second face 10B side, and adjacent turns are arranged offset from each other. The coil 20W comprises three turns of wires. The first wire 30WF and the second wire 30WB constituting each turn are electrically connected through via conductors 31W penetrating the flexible board 10.

The configuration of the coils 22U, 22V, 22W is also the same as the configuration of the coils 20U, 20V, 20W. The coil 22U is formed by means of first wires 32UF, second wires 32UB, and via conductors 33U. The coil 22V is formed by means of first wires 32VF, second wires 32VB, and via conductors 33V. The coil 22W is formed by means of first wires 32WF, second wires 32WB, and via conductors 33W.

Portions of the second wires 30UB of the coil 20U overlap, through the flexible board 10, portions of the first wires 32UF of the U-phase coil 22U of the adjacent set. Portions of the second wires 30VB of the coil 20V overlap, through the flexible board 10, portions of the first wires 32VF of the V-phase coil 22V of the adjacent set. Portions of the second wires 30WB of the coil 20W overlap, through the flexible board 10, portions of the first wires 32WF of the W-phase coil 22W of the adjacent set. The arrangement in fig. 1 is an example, and in another modified example, portions of the second wires 30UB, 30VB, 30WB constituting the coils 20U, 20V, 20W need not overlap portions of the first wires 32UF, 32VF, 32WF constituting the coils 22U, 22V, 22W.

The first face 10F and the first wires 30UF, 30VF, 30WF, 32UF, 32VF, 32WF are covered over by a resin insulating layer, although this is not shown in the drawings. The second face 10B and the second wires 30UB, 30VB, 30WB, 32UB, 32VB, 32WB are likewise covered over by a resin insulating layer.

Fig. 2 is a view in cross section of a portion of the coil board 2 of the embodiment. Fig. 2 is a view in the cross section between II-II in fig. 1. As shown in fig. 2, an inter-wire distance D1 between the first wires 32UF constituting the U-phase coil 22U and the first wires 32VF constituting the V-phase coil 22V on the first face 10F side is greater than an inter-wire distance D2 of the first wires 32UF constituting the coil 22U and an inter-wire distance D3 of the first wires 32VF constituting the coil 22V. The inter-wire distance D2 and the inter-wire distance D3 are largely the same, but a difference commensurate with positions when the coil board 2 is wound into a cylindrical shape may also be provided.

In the same way, an inter-wire distance D4 between the second wires 30UB constituting the U-phase coil 20U and the second wires 30VB constituting the V-phase coil 20V on the second face 10B side is greater than an inter-wire distance D5 of the second wires 30UB constituting the coil 20U and an inter-wire distance D6 of the second wires 30VB constituting the coil 20V. The inter-wire distance D5 and the inter-wire distance D6 are largely the same, but a difference commensurate with positions when the coil board 2 is wound into a cylindrical shape may also be provided.

Furthermore, the inter-wire distance D2 is greater than the inter-wire distance D5. The inter-wire distance D3 is greater than the inter-wire distance D6. The widths of the first wires 32UF, 32VF are smaller than the widths of the second wires 30UB, 30BV. The inter-wire distance D1 is therefore greater than the inter-wire distance D4.

The example in fig. 2 illustrates only a relationship of the coil 20U (U phase) and the coil 20V (V phase), and the coil 22U (U phase) and the coil 22V (V phase), but the relationships between adjacent coils of different phases (relationship of the coil 20V (V phase) and the coil 20W (W phase), and relationship of the coil 20W (W phase) and the coil 22U (U phase) of the adjacent set, etc.) are also the same as the relationship illustrated in fig. 2.

Fig. 3 is an oblique view schematically showing a motor coil board 50 employing the coil board 2 of the embodiment (fig. 1 and 2). As shown in fig. 3, the motor coil board 50 for a motor is formed by winding the coil board 2 of the embodiment (fig. 1 and 2) into a cylindrical shape. When the coil board 2 is wound into a cylindrical shape, it is wound in a circumferential direction about an axis parallel to the short side 10S at one end, starting from one end of the long side 10L (fig. 1). The coil board 2 is wound around multiple times. When it is wound into a cylindrical shape, the first face 10F is arranged on the inner circumferential side and the second face 10B is arranged on the outer circumferential side.

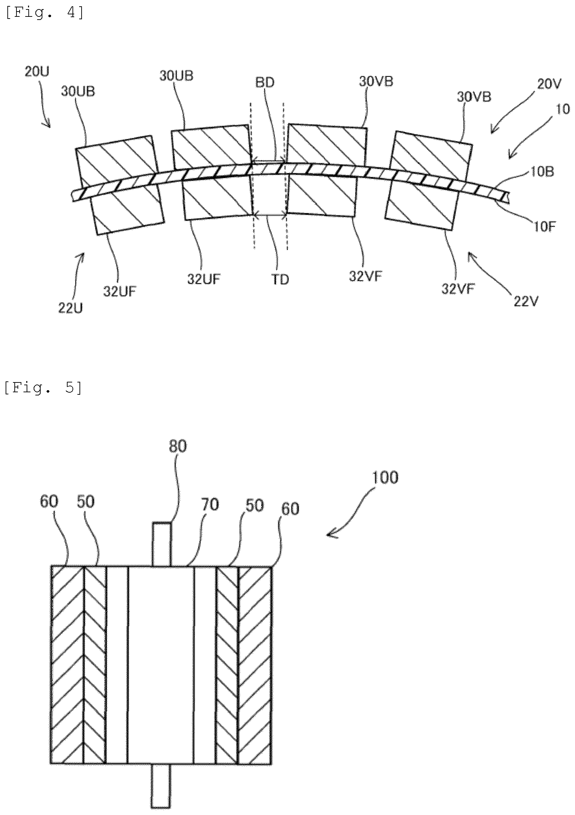

Fig. 4 is an enlarged explanatory diagram of the part IV in fig. 3. As shown in fig. 4, a distance TD between top portions of the first wires 32UF of the coil 22U and the first wires 32VF of the coil 22V, which are arranged on the inner circumferential side, is largely equal to a distance BD between bottom portions of the second wires 30UB of the coil 20U and the second wires 30VB of the coil 20V, which are arranged on the outer circumferential side. The top portions of the first wires 32UF, 32VF are the parts of the first wires 32UF, 32VF at the greatest height from the first face 10F. The bottom portions of the second wires 30UB, 30VB are the parts of the second wires 30UB, 30VB touching the second face 10B. The distances TD, BD are 10 µm-50 µm (preferably 15 µm-30 µm), for example.

Fig. 5 is a view in cross section schematically showing a motor 100 employing the motor coil board 50 of the embodiment (fig. 3 and 4). The motor 100 is formed by arranging the motor coil board 50 on the inside of a yoke 60, and arranging a rotary shaft 80 and a magnet 70, which is fixed to the rotary shaft 80, on the inside of the motor coil board 50.

The configurations of the coil board 2 (fig. 1 and 2), the motor coil board 50 (fig. 3 and 4), and the motor 100 (fig. 5) of the embodiment are as described above. As shown in fig. 2, in the coil board 2 of the embodiment, the inter-wire distance D1 between the first wires 32UF constituting the U-phase coil 22U and the first wires 32VF constituting the V-phase coil 22V is greater than the inter-wire distance D2 of the first wires 32UF constituting the coil 22U and the inter-wire distance D3 of the first wires 32VF constituting the coil 22V. The inter-wire distance D4 between the second wires 30UB constituting the U-phase coil 20U and the second wires 30VB constituting the V-phase coil 20V is greater than the inter-wire distance D5 of the second wires 30UB constituting the coil 20U and the inter-wire distance D6 of the second wires 30VB constituting the coil 20V. When the motor coil board 50 (fig. 3 and 4) is formed by using the coil board 2 of the embodiment, a distance is therefore maintained between the first wires 32UF constituting the coil 22U and the first wires 32VF constituting the adjacent coil 22V on the first face 10F on the inner circumferential side, and there is no contact between the wires. A distance is likewise maintained between the second wires 30UB constituting the coil 20U and the second wires 30VB constituting the adjacent coil 20V on the second face 10B on the outer circumferential side also. When the motor 100 is formed by using the coil board 2 comprising coils of multiple phases (three phases to be specific), the withstand voltage of the motor 100 is ensured, and a motor 100 having stable performance can be obtained.

The coil 20U and the coil 20V in fig. 2, and the coil 22U and the coil 22V in fig. 2 are an example of the "N^{th} coil" and the "N+1^{th} coil". The inter-wire distances D1 and D4 are an example of the "inter-wire distance between the wires constituting the N^{th} coil and the wires constituting the N+1^{th} coil". The inter-wire distances D2 and D5 are an example of the "inter-wire distance of the wires constituting the N^{th} coil". The inter-wire distances D3 and D6 are an example of the "inter-wire distance of the wires constituting the N+1^{th} coil".

### [Different example 1 of the embodiment]

In different example 1 of the embodiment, the widths of the first wires 30UF, 30VF are largely equal to the widths of the second wires 32UB, 32VB. The inter-wire distance D2 is equal to the inter-wire distance D5. The inter-wire distance D3 is equal to the inter-wire distance D4. In this case also, the inter-wire distance D1 is greater than the inter-wire distances D2 and D3. The inter-wire distance D4 is greater than the inter-wire distances D5 and D6. The inter-wire distance D1 may be greater than the inter-wire distance D4 or equal to the inter-wire distance D4.

### [Different example 2 of the embodiment]

In different example 2 of the embodiment, the coil board 2 is provided with coils of multiple phases comprising four or more phases. In this case, the inter-wire distance between the wires constituting the N^{th} (N = 1, 2...) coil of the N^{th} phase and the wires constituting the N+1^{th} coil of the N+1^{th} phase is greater than the inter-wire distance of the wires constituting the N^{th} coil and the inter-wire distance of the wires constituting the N+1^{th} coil.

### [First modified example of the embodiment]

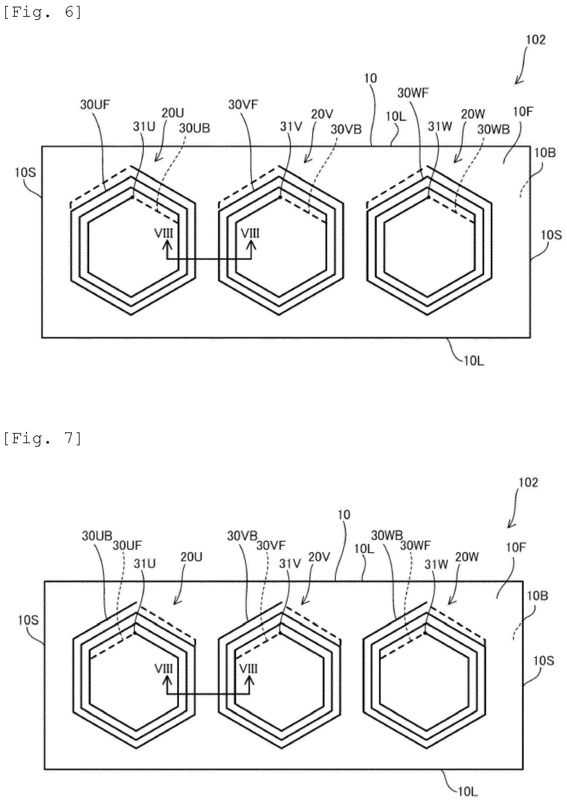

Fig. 6-8 show a first modified example of the embodiment. In the first modified example, the arrangement of the wires constituting the coils 20U, 20V, 20W differs from that of the embodiment. Fig. 6 is a plan view showing a coil board 102 according to the first modified example. Fig. 7 is a bottom view showing the coil board 102 according to the first modified example. In the first modified example, the flexible board 10 is provided with one set of three-phase coils 20U, 20V, 20W, as shown in fig. 6 and 7. In another example, the flexible board 10 may be provided with 3Y (where Y is an integer of 2 or more) coils (i.e., two or more sets of three-phase coils) .

The coil 20U constituting the U phase comprises: coil-shaped first wires 30UF provided on the first face 10F (fig. 6) and coil-shaped second wires 30UB provided on the second face 10B (fig. 7). The first wires 30UF and the second wires 30UB are electrically connected through a via conductor 31U penetrating the flexible board 10. The coil 20V constituting the V phase likewise comprises first wires 30VF and second wires 30VB. The first wires 30VF and the second wires 30VB are electrically connected through a via conductor 31V. The coil 20W constituting the W phase comprises first wires 30WF and second wires 30WB. The first wires 30WF and the second wires 30WB are electrically connected through a via conductor 31W.

As shown in fig. 6, the first wires 30UF are formed in a spiral shape (hexagonal spiral shape) winding clockwise from the outer circumference toward the inner circumference. The via conductor 31U is formed at an inner circumferential end of the first wires 30UF. As shown in fig. 7, the second wires 30UB are formed in a spiral shape (hexagonal spiral shape) winding counterclockwise from the outer circumference toward the inner circumference. The via conductor 31U is formed at an inner circumferential end of the second wires 30UB. The first wires 30UF and the second wires 30UB are formed in spiral shapes with the same winding direction when seen from the same face. The first wires 30UF and the second wires 30UB function as one coil 20U in which they are electrically connected in series.

The first wires 30VF and second wires 30VB and the first wires 30WF and second wires 30WB have the same relationship as that of the first wires 30UF and second wires 30UB. The first wires 30VF and second wires 30VB are formed in spiral shapes with the same winding direction when seen from the same face. The first wires 30VF and second wires 30VB function as one coil 20V in which they are electrically connected in series. The first wires 30WF and second wires 30WB are formed in spiral shapes with the same winding direction when seen from the same face. The first wires 30WF and second wires 30WB function as one coil 20W in which they are electrically connected in series.

Furthermore, the first face 10F and the first wires 30UF, 30VF, 30WF are covered over by a resin insulating layer, although this is not shown in the drawings. The second face 10B and the second wires 30UB, 30VB, 30WB are likewise covered over by a resin insulating layer.

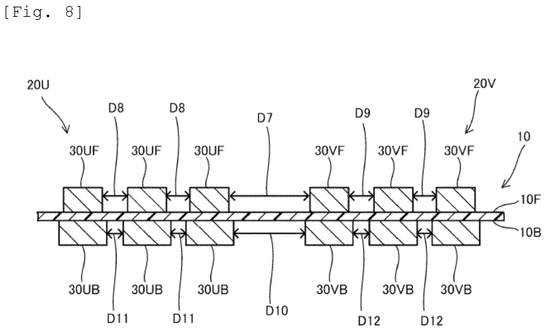

Fig. 8 is a view in cross section of a portion of the coil board 102. Fig. 8 is a view in the cross section between VIII-VIII in fig. 7. A relationship of the coil 20U (first wires 30UF and second wires 30UB) and the coil 20V (first wires 30VF and second wires 30VB) will be described in detail with reference to fig. 8. Fig. 3 shows a cross section of a portion of the coil 20U and the coil 20V, but the coil 20V and the coil 20W also have the same relationship.

As shown in fig. 8, the first wires 30UF on the first face 10F and the second wires 30UB on the second face 10B are overlapping through the flexible board 10 in a thickness direction (a vertical direction in the drawing). The first wires 30VF on the first face 10F and the second wires 30VB on the second face 10B are overlapping through the flexible board 10 in the thickness direction.

An inter-wire distance D7 between the first wires 30UF constituting the U-phase coil 20U and the first wires 30VF constituting the V-phase coil 20V on the first face 10F side is greater than an inter-wire distance D8 of the first wires 30UF constituting the coil 20U and an inter-wire distance D9 of the first wires 30VF constituting the coil 20V. The inter-wire distance D8 and the inter-wire distance D9 are largely the same, but a difference commensurate with positions when the coil board 102 is wound into a cylindrical shape may also be provided.

In the same way, an inter-wire distance D10 between the second wires 30UB constituting the U-phase coil 20U and the second wires 30VB constituting the V-phase coil 20V on the second face 10B side is greater than an inter-wire distance D11 of the second wires 30UB constituting the coil 20U and an inter-wire distance D12 of the second wires 30VB constituting the coil 20V. The inter-wire distance D11 and the inter-wire distance D12 are largely the same, but a difference commensurate with positions when the coil board 102 is wound into a cylindrical shape may also be provided.

Furthermore, the inter-wire distance D8 is greater than the inter-wire distance D11. The inter-wire distance D9 is greater than the inter-wire distance D12. The widths of the first wires 30UF, 30VF are smaller than the widths of the second wires 30UB, 30BV. The inter-wire distance D7 is therefore greater than the inter-wire distance D10.

When the motor coil board 50 (fig. 3 and 4) is formed by using the coil board 102 of the first modified example (fig. 6-8), a distance is therefore maintained between the first wires 30UF constituting the coil 20U and the first wires 30VF constituting the adjacent coil 20V on the first face 10F on the inner circumferential side. A distance is likewise maintained between the second wires 30UB constituting the coil 20U and the second wires 30VB constituting the adjacent coil 20V on the second face 10B on the outer circumferential side also. When the motor 100 is formed by using the coil board 102 comprising coils of multiple phases (three phases to be specific), the withstand voltage of the motor 100 is ensured, and a motor 100 having stable performance can be obtained.

### [Different example 1 of first modified example]

In different example 1 of the first modified example, the widths of the first wires 30UF, 30VF in fig. 8 are largely equal to the widths of the second wires 30UB, 30VB. The inter-wire distance D8 is equal to the inter-wire distance D11. The inter-wire distance D9 is equal to the inter-wire distance D12. In this case also, the inter-wire distance D7 is greater than the inter-wire distances D8 and D9. The inter-wire distance D10 is greater than the inter-wire distances D11 and D12. The inter-wire distance D7 may be greater than the inter-wire distance D10 or equal to the inter-wire distance D10.

### [Different example 2 of first modified example]

In different example 2 of the first modified example, the coil board 102 is provided with coils of multiple phases comprising four or more phases. In this case, the inter-wire distance between the wires constituting the N^{th} (N = 1, 2...) coil of the N^{th} phase and the wires constituting the N+1^{th} coil of the N+1^{th} phase is greater than the inter-wire distance of the wires constituting the N^{th} coil and the inter-wire distance of the wires constituting the N+1^{th} coil.

### Key to Symbols

- 2:: Coil board
- 10:: Flexible board
- 10F:: First face
- 10B:: Second face
- 20U, 20V, 20W:: Coil
- 22U, 22V, 22W:: Coil
- 50:: Motor coil board
- 60:: Yoke
- 70:: Magnet
- 80:: Rotary shaft
- 100:: Motor
- 102:: Coil board

## Claims

1. A coil board comprising:
a flexible board having a first face and a second face on the opposite side to the first face; and
a plurality of coils formed by coil-shaped wires provided on the first face and coil-shaped wires provided on the second face,
wherein the plurality of coils include an N^{th} (N = 1, 2...) coil forming an N^{th} phase, and an N+1^{th} coil forming an N+1^{th} phase, the N+1^{th} coil being arranged next to the N^{th} coil, and
an inter-wire distance between the wires constituting the N^{th} coil and the wires constituting the N+1^{th} coil is greater than an inter-wire distance of the wires constituting the N^{th} coil and an inter-wire distance of the wires constituting the N+1^{th} coil.

2. The coil board of claim 1, wherein each of the plurality of coils comprises: a half-turn wire formed on the first face; a half-turn wire formed on the second face; and a via conductor which penetrates the flexible board and connects the half-turn wire on the first face and the half-turn wire on the second face.

3. A motor coil board formed by winding the coil board of claim 1 into a cylindrical shape, wherein the first face is arranged on an inner circumferential side and the second face is arranged on an outer circumferential side.

4. A motor formed by arranging the motor coil board of claim 3 on the inside of a cylindrical yoke, and arranging a rotary shaft and a magnet on the inside of the motor coil board.
